Europäisches Patentamt

European Patent Office

Office européen des brevets

(19)

(11) Numéro de publication: **0 053 786**
**B1**

(12) **FASCICULE DE BREVET EUROPEEN**

(45) Date de publication du fascicule du brevet: **29.05.85**

(51) Int. Cl.⁴: **G 01 R 27/02**, G 01 R 19/25

(21) Numéro de dépôt: **81110034.6**

(22) Date de dépôt: **01.12.81**

(54) **Circuit de mesure de résistance.**

(30) Priorité: **05.12.80 FR 8025854**

(43) Date de publication de la demande:
**16.06.82 Bulletin 82/24**

(45) Mention de la délivrance du brevet:
**29.05.85 Bulletin 85/22**

(84) Etats contractants désignés:
**BE DE FR GB NL SE**

(56) Documents cités:
**ELECTRONICS, vol. 53, 6 novembre 1980, no. 24 NEW YORK (US) J. WILLIAMS: "Single-slope-a-d converter makes a comeback with 20-bit linearity" pages 151-155
ELEKTRONIK, vol. 29, novembre 1980, no. 23, MÜNCHEN (DE) M. VALENTATEN: "Preiswertes A/D-Umsetzsystem mit Mikrocontroller" pages 79-82**

(73) Titulaire: **Société Anonyme dite SAFT
156, avenue de Metz
F-93230 Romainville (FR)**

(72) Inventeur: **Belot, Pierre
111, allée Danièle Casanova
F-93320 Pavillons Sous Bois (FR)**

(74) Mandataire: **Weinmiller, Jürgen et al
Zeppelinstrasse 63
D-8000 München 80 (DE)**

Courier Press, Leamington Spa, England.

## Description

La présente invention concerne un circuit de mesure de résistances électriques présentant un résultat de mesure mis sous forme numérique.

Ou peut faire de telles mesures à l'aide d'un convertisseur analogique-numérique à simple rampe tel que celui décrit dans l'article de J. Williams paru dans la revue Electronics, volume 53, 6 XI 80, No. 24, pages 151 à 155. Ce convertisseur analogique-numérique simple rampe est piloté par un processeur logique. Il comporte un générateur de rampe de tension formé d'un capacité chargée à courant constant et périodiquement déchargé sur ordre du processeur logique, et un comparateur recevant sur une entrée les rampes de tension et sur l'autre, par l'intermédiaire d'un multiplexeur soit une tension nulle, soit une tension de référence dite de pleine échelle, soit une tension inconnue. Le processeur logique mesure par comptage d'impulsions d'horloge, les délais mis par une première rampe de tension pour atteindre la tension nulle, puis par une deuxième rampe de tension pour atteindre la tension de référence et enfin par une troisième rampe de tension pour atteindre la tension inconnue et détermine la tension inconnue à partir du rapport entre la différence des délais mesurés pour la tension inconnue et la tension nulle, et la différence des délais mesurés pour la tension de pleine échelle et la tension inconnue.

Ce convertisseur simple rampe a l'inconvénient d'être lent en raison des trois rampes de tension successives nécessaires pour une mesure complète et ne nécessiter pour la mesure de résistance, un certain nombre de dispositifs auxiliaires tels que: pont de résistance, référence de tension.

La présente invention a pour but un circuit de mesure de résistance à convertisseur analogique-numérique à simple rampe piloté par un processeur logique qui soit simple, avec un nombre de composants réduits pour en diminuer le coût.

Elle a pour objet un circuit de mesure de résistance comportant:

— une résistance de référence connectée en série avec la résistance à mesurer aux bornes d'une source de tension de polarisation l'une desdites bornes étant reliée à la masse;

— un convertisseur analogique-numérique simple rampe comportant un condensateur shunté par un interrupteur commandé et connecté entre la masse et une source à courant constant, elle-même raccordée à la source de tension de polarisation, un comparateur analogique comportant une sortie et deux entrées à haute impédance, l'une connectée entre le condensateur et la source à courant constant, l'autre constituant l'entrée du convertisseur analogique-numérique, une horloge et un processeur logique assurant le déroulement des cycles de conversion analogique-numérique et commandant à chaque conversion analogique-numérique la fermeture de l'interrupteur commandé pour décharger le condensateur puis, simultanément, l'ouverture de ce même interrupteur commandé pour charger le condensateur à courant constant et le comptage des impulsions d'horloge, et enfin la mémorisation du nombre atteint au basculement du comparateur analogique;

— un atténuateur de tension connecté à l'entrée du convertisseur analogique-numérique et

— un multiplexeur à deux entrées et une sortie, connecté, en entrée d'une part au point de connexion de la résistance à mesurer et de la résistance de référence, et d'autre part à la source de tension de polarisation, et, en sortie à l'entrée de l'atténuateur, ledit multiplexeur étant commandé pendant chaque conversion analogique-numérique pour connecter l'entrée de l'atténuateur successivement au point de connexion des résistances à mesurer et de référence puis à la source de tension de polarisation, le passage de l'un à l'autre s'effectuant au premier basculement du comparateur analogique qui repasse alors à son état initial pour basculer une deuxième fois ultérieurement, le processeur logique du convertisseur analogique-numérique étant équipé pour mémoriser successivement au cours de chaque conversion analogique-numérique le nombre d'impulsions d'horloge comptées depuis l'ouverture de l'interrupteur commandé jusqu'au premier basculement du comparateur analogique et le nombre d'impulsions d'horloge comptées depuis l'ouverture de l'interrupteur commandé jusqu'au deuxième basculement du comparateur analogique et pour calculer le rapport du premier nombre par le second, ce rapport étant représentatif de la valeur de la résistance à mesurer en fonction de celle de la résistance de référence.

Le processeur logique procède par comptage du nombre d'impulsions de l'horloge apparaissant pendant la durée nécessaire à la capacité chargée à courant constant pour atteindre la valeur de la tension aux bornes de la résistance à mesurer. Il est programmé pour effectuer une mesure de résistance au cours d'un cycle de conversion analogique-numérique. En dehors des cycles de conversion analogique-numérique il adresse le multiplexeur de manière à appliquer sur l'atténuateur la tension développée au point de liaison des résistances à mesurer et de référence et il commande le court-circuitage de la capacité. Au cours d'un cycle de conversion analogique-numérique il commence par arrêter le cour-circuitage de la capacité et à compter les impulsions d'horloge apparaissant au cours de la charge à courant constant de la capacité. Il mémorise une première fois le compte obtenu lorsque la tension aux bornes de la capacité atteint la valeur de cell du point de liaison des résistances à mesurer et de référence divisée par le rapport de réduction de l'atténuateur et, simultanément, il change l'addressage du multiplexeur tout en poursuivant le comptage. Il mémorise une deuxième fois le compte obtenu lorsque la tension aux bornes de la capacité atteint la valeur de celle de la source de polarisation divisée par le rapport de réduction de l'atténuateur et il divise enfin le premier compte mémorisé par le second pour obtenir un rapport représentatif de la valeur de la résistance à mesurer en fonction de celle de la résistance de référence.

D'autres caractéristiques et avantages de l'invention ressortiront des revendications jointes et de la description ci-après d'un exemple de réalisation. Cette description sera faite en regard du dessin dans lequel:

— la figure 1 est un schéma électrique d'un circuit de mesure de résistance conforme à l'invention

— et la figure 2 est un diagramme de courbes explicitant le fonctionnement du circuit représenté à la figure précédente.

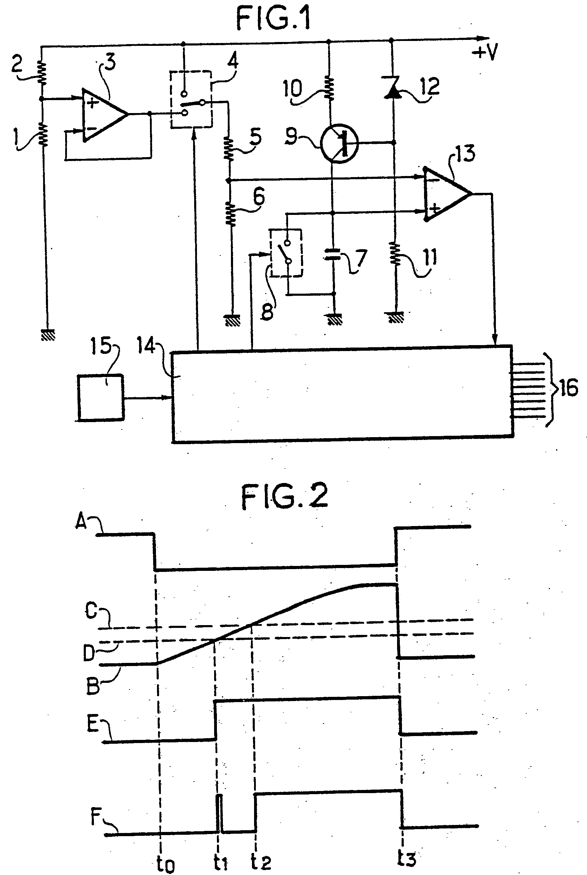

Dans le circuit représenté à la figure 1 la résistance à mesurer 1 a une extrémité connectée directement à la masse et l'autre, par l'intermédiaire d'une résistance de référence 2, à la borne +V d'une source de tension de polarisation. Un amplificateur opérationnel 3 monté en séparateur à gain unité est connecté en entrée au point di liaison des résistances à mesurer 1 et de référence 2. Un multiplexeur 4 à deux entrées relie un atténuateur de tension soit à la sortie de l'amplificateur opérationnel 3, soit à la borne +V de la source de tension de polarisation. Cet atténuateur de tension est formé des résistances 5 et 6 connectées en série entre la masse et la sortie du multiplexeur 4. Un condensateur 7 shunté par un interrupteur commandé 8 est connecté entre la masse et le collecteur d'un transistor 9 de type PNP monté en source de courant avec son émetteur relié à la borne +V de la source de tension de polarisation au moyen d'un résistance 10 et sa base reliée à la masse par une résistance 11 et à la borne +V de la source de tension de polarisation par une diode Zener 12. Un comparateur analogique 13 à deux entrées à haute impédance est connecté par son entrée inverseuse à la sortie de l'atténuateur de tension au point de connexion des résistances 5 et 6, et par son entrée non inverseuse au collecteur du transistor 9. Un processeur logique 14 commande l'adressage du multiplexeur 4 et la manoeuvre de l'interrupteur commandé 8 sous le contrôle d'une horloge 15 et du comparateur analogique 13. Il délivre sur une sortie parallèle de données 16 un nombre binaire représentatif de la valeur de la résistance à mesurer 1 en fonction de la valeur de la résistance de référence 2.

La condensateur 7 constitue avec l'interrupteur commandé 8, avec la source de courant formée du transistor 9, des résistances 10, 11 et de la diode Zener 12, et avec le comparateur analogique 13, la partie analogique d'un convertisseur analogique-numérique simple rampe. L'interrupteur 8 permet de décharger le condensateur 7 entre les cycles de conversion analogique-numérique. Le transistor 9 permet la charge à courant constant du condensateur 7 lorsque l'interrupteur commandé 8 est ouvert. Le comparateur analogique 13 permet de détecter l'instant de coïncidence entre la tension de charge du condensateur 7 et la tension développée au point de connexion des résistances 5 et 6 de l'atténuateur.

Le transistor 9 cesse de fonctionner en source de courant et a tendance à se bloquer lorsque la tension de charge du condensateur 7 se rapproche de la tension +V de la source de tension de polarisation diminuée de la tension de la diode Zener 12. L'atténuateur formé des résistances 5 et 6 permet de maintenir la tension à convertir dans la plage où le condensateur 7 est effectivement chargé à courant constant.

Le processeur logique 14, réalisé par exemple à l'aide d'un microprocesseur et de ses interfaces, gère les cycles de conversion analogique-numérique. Il est programmé pour:

— en dehors des cycles de conversion analogique-numérique, rendre l'interrupteur commandé 8 passant afin de maintenir le condensateur déchargé et adresser le multiplexeur 4 de manière à appliquer sur l'atténuateur la tension $V_e$ développée au point de liaison des résistances 1 de mesure et 2 de référence

— et successivement, au cours d'un cycle de conversion analogique-numérique,

. bloquer l'interrupteur commandé 8 de manière à débuter la charge à courant constant du condensateur 7 et, simultanément, entamer le comptage des impulsions d'horloge,

. mémoriser une première fois le compte obtenu au basculement du comparateur analogique 13 indiquant que la tension développée aux bornes du condensateur 7 chargé à courant constant passe par la valeur de la tension $V_e$ divisée par le rapport de réduction de l'atténuateur et, simultanément, adresser le multiplexeur 4 de manière à appliquer sur l'atténuateur la tension +V de la source de polarisation, ce changement d'addresse provoquant le retour à l'état initial du comparateur analogique 13,

. mémoriser une deuxième fois le compte obtenu au deuxième basculement du comparateur analogique 13 indiquant que la tension développée aux bornes du condensateur 7 chargé à courant constant passe par la valeur de la tension + de la source de polarisation divisée par le rapport de réduction de l'atténuateur,

. diviser le premier compte obtenu par le second pour obtenir un rapport représentatif de la valeur de la résistance à mesurer en fonction de celle de la résistance de référence.
— et délivrer ledit rapport sous forme numérique sur sa sortie 16.

Soit R la valeur de la résistance 1 à mesurer et R' celle de la résistance 2 de référence. La tension $V_e$ développée au point de connexion des résistances 1 à mesurer et 2 de référence s'exprime en fonction de la tension $+V$ de la source de polarisation par la relation:

$$V_e = \frac{R}{R+R'} V$$

Le premier compte mémorisé N correspond à la durée NT, T étant la période de l'horloge, nécessaire au condensateur 7, de capacité C, initialement déchargé, pour atteindre, par une charge à courant constant d'intensité I, la tension $V_e$ divisée par le rapport de réduction $\alpha$ de l'atténuateur ce qui peut s'écrire:

$$NT = \frac{c}{I} \frac{V_e}{\alpha}$$

De même, le deuxième compte mémorisé D correspond à la durée DT nécessaire au condensateur 7 de capacité C, initialement déchargé, pour atteindre, par une charge à courant constant d'intensité I, la tension $+V$ de la source de polarisation divisée par le rapport de réduction $\alpha$ de l'atténuateur:

$$DT = \frac{c}{I} \frac{V}{\alpha}$$

Le rapport N/D calculé par le processeur logique est donc égal à:

$$\frac{N}{D} = \frac{V_e}{V} = \frac{R}{R+R'}$$

La valeur R de la résistance à mesurer s'en déduit alors facilement par la relation:

$$R = \frac{N}{D} \left( \frac{1}{1 - \frac{N}{D}} \right) R'$$

La figure 2 est un diagramme de courbes tracées en fonction du temps illustrant les signaux disponibles en divers points du circuit de la figure 1 avant, pendant et après un cycle de conversion analogique-numérique.

La courbe A représente le signal logique de commande de l'interrupteur commandé 8. Il correspond à une commande de fermeture lorsqu'il est à l'état haut et à une commande d'ouverture lorsqu'il est à l'état bas. Il bascule de l'état haut à l'état bas à l'instant $t_0$ correspondant au début d'un cycle de mesure et revient à l'état haut à l'instant $t_3$ correspondant à la fin d'un cycle de mesure.

La courbe B représente la tension aux bornes de condensateur 7. Celle-ci est nulle en dehors de l'intervalle de temps $t_0$ $t_3$ car l'interrupteur commandé 8 est conducteur. Elle augmente de façon linéaire dès l'ouverture de l'interrupteur commandé jusqu'à une tension proche de celle $+V$ de la source de polarisation diminuée de la tension développée aux bornes de la diode Zener 12. Le niveau $+V/\alpha$ est représenté par rapport à cette courbe B par une ligne pointillée C et le niveau $V_e/\alpha$ par une ligne pointillée D. Le rapport de réduction $\alpha$ de l'atténuateur est choisi de manière que le niveau $+V/\alpha$ soit dans le domaine de variation linéaire de la tension aux bornes du condensateur 7. Il est pris par exemple égal à un demi. L'instant où la tension développée aux bornes du condensateur 7 prend la valeur $V_e/\alpha$ est repéré par $t_1$ et celui où elle prend la valeur $V/\alpha$ par $t_2$.

La courbe E représente le signal logique d'adressage du multiplexeur 4. Lorsque ce signal est à l'état bas le multiplexeur 4 relie sa sortie avec le point de liaison des résistances à mesurer 1 et de référence 2 et lorsqu'il est à l'état haut le multiplexeur 4 relie sa sortie avec la borne $+V$ de la source de tension de polarisation. Il passe de l'état bas à l'état haut à l'instant $t_1$ où la tension aux bornes du condensateur 7 atteint la valeur $V_e/\alpha$ et revient à l'état bas à l'instant $t_3$ marquant la fin d'un cycle de mesure.

La courbe F représente le signal de sortie du comparateur analogique 13. Ce signal binaire est à l'état bas en dehors de l'intervalle $t_0$ $t_3$ d'un cycle de mesure car l'entrée non inverseuse du comparateur analogique 13 reliée au condensateur 7 est mise à la masse par l'intermédiaire de l'interrupteur commandé 8 qui est alors conducteur. Il reste à l'état bas, au début d'un cycle de mesure dans l'intervalle de temps $t_0$, $t_1$ tant que la tension développée aux bornes du condensateur 7 est inférieure à celle $V_e/\alpha$ délivrée par l'atténuateur. Il passe à l'état haut à l'instant $t_1$ où la tension aux bornes du condensateur 7 parvient à la valeur $V_e/\alpha$ puis repasse à l'état bas peu de temps après en raison du changement d'adresse du multiplexeur qui commute l'entrée de l'atténuateur sur la tension $+V$ de la source de polarisation. Il reste à l'état bas pendant l'intervalle de temps $t_1+\varepsilon$, $t_2$ tant que la tension développée aux bornes du condensateur 7 n'atteint pas la valeur $V/\alpha$ et passe enfin à l'état haut à l'instant $t_2$ pour le rester jusqu'à la fin d'un cycle de mesure.

En dehors de l'intervalle de temps $t_0$, $t_3$ le processeur logique 14 maintient l'interrupteur commandé 8 fermé et adresse le multiplexeur 4 de manière à connecter l'atténuateur à la sortie de l'amplificateur opérationnel 3.

A l'instant $t_0$ où commence un cycle de mesure, le processeur logique 14 ouvre l'interrupteur commandé 8 et commence à compter les impulsions du circuit d'horloge 15.

Le comptage continue jusqu'à l'instant $t_1$ où le comparateur analogique 13 bascule indiquant au processeur logique 14 que la tension développée aux bornes du condensateur 7 a atteint la valeur $V_e/\alpha$. Le processeur logique 14 mémorise l'état de comptage N et change l'adressage du multiplexeur 4. Le comparateur analogique 13 reçoit alors sur sont entrée inverseuse une tension $V/\alpha$ supérieure à celle $V_e/\alpha$ appliquée sur son entrée non inverseuse par le condensateur 7 et revient à son état initial.

Le processeur logique 14 continue à compter les impulsions du circuit d'horloge 15 jusqu'à l'instant $t_2$ où le comparateur bascule à nouveau, la tension développée aux bornes du condensateur 7 avant atteint la valeur $V/\alpha$. Le processeur logique 14 arrête le comptage et mémorise l'état de comptage D atteint.

Au cours de l'intervalle de temps $t_2$ $t_3$ le processeur logique 14 effectue la division du nombre N par le nombre D et délivre le résultat sur sa sortie parallèle de données 16.

A l'instant $t_3$ le processeur logique 14 remet le système dans ses conditions initiales. Il ferme l'interrupteur commandé 8, change l'adressage du multiplexeur 4 et remet son compteur à zéro.

Le processeur logique 14 peut être trop lent pour effectuer, au temps $t_1$, entre deux impulsions d'horloge, la mémorisation du compte N et le changement d'adresse du multiplexeur 4 de sorte qu'il peut laisser passer une ou plusieurs impulsions d'horloge avant de redémarrer le comptage. Pour corriger cette erreur il suffit de repérer le nombre d'impulsions d'horloge que échappent au comptage et de l'ajouter forfaitairement au compte D avant sa mémorisation.

Les cycles de mesure peuvent être séparés par des intervalles de temps plus ou moins long où le processeur logique 14 est affecté à d'autres tâches telles que par exemple le traitement des informations tirées des mesures de résistances lorsque ces dernières sont celles de capteurs résistifs.

**Revendications**

1. Circuit de mesure de résistance comportant:

— une résistance de référence (2) connectée en série avec la résistance à mesurer (1) aux bornes d'une source de tension de polarisation (+V), l'une desdites bornes étant reliée à la masse;

— un convertisseur analogique-numérique simple rampe comportant un condensateur (7) shunté par un interrupteur commandé (8) et connecté entre la masse et une source à courant constant elle-même raccordée à la source de tension de polarisation (+V), un comparateur analogique (13) comportant une sortie et deux entrées à haute impédance, l'une connectée entre le condensateur (7) et la source à courant constant, l'autre constituant l'entrée du convertisseur analogique-numérique, une horloge (15) et un processeur logique (14) assurant le déroulement des cycles de conversion analogique-numérique et commandant à chaque conversion analogique-numérique la fermeture de l'interrupteur commandé (8) pour décharger le condensateur (7) puis, simultanément, l'ouverture de ce même interrupteur commandé (8) pour charger le condensateur (7) à courant constant et le comptage des impulsions d'horloge (15), et enfin la mémorisation du nombre atteint un basculement du comparateur analogique (13);

— un atténuateur de tension (5, 6) connecté à l'entrée du convertisseur analogique-numérique; et

— un multiplexeur (4) à deux entrées et une sortie, connecté, en entrée d'une part au point de connexion de la résistance à mesurer (1) et de la résistance de référence (2), et d'autre par à la source de tension de polarisation (+V), et, en sortie à l'entrée de l'atténuateur (5, 6), ledit multiplexeur étant commandé pendant chaque conversion analogique-numérique pour connecter l'entrée de l'atténuateur (5, 6) successivement au point de connexion des résistances à mesurer (1) et de référence (2) puis à la source de tension de polarisation (+V), le passage de l'un à l'autre s'effectuant au premier basculement du comparateur analogique (13) qui repasse alors à son état initial pour basculer une deuxième fois ultérieurement, le processeur logique (14) du convertisseur analogique-numérique étant équipé pour mémoriser successivement au cours de chaque conversion analogique-numérique le nombre (N) d'impulsions d'horloge (15) comptées depuis l'ouverture de l'interrupteur commandé (8) jusqu'au premier basculement du comparateur analogique (13) et le nombre (D) d'impulsions d'horloge (15) comptées depuis l'ouverture de l'interrupteur commandé (8) jusqu'au deuxième basculement du comparateur analogique (13) et pour calculer le rapport du premier nombre (N) par le second (D), ce rapport étant représentatif de la valeur de la résistance à mesurer (1) en fonction de celle de la résistance de référence (2).

2. Circuit selon la revendication 1, caractérisé en ce qu'un étage séparateur (3) à grande impédance d'entrée est intercalé entre le point de connexion des résistances à mesurer (1) et de référence (2), et le multiplexeur (4).

**Patentansprüche**

1. Widerstandsmeßkreis mit:

— einem Bezugswiderstand (2), der in Reihe mit dem zu messenden Widerstand (1) an die Klemmen einer Vorspannungsquelle (+V) angeschlossen ist, wobei eine der Klemmen mit Masse verbunden ist,

— einem Einfachrampen-Analog-Digitalwandler, der einen Kondensator (7) aufweist, welchem ein gesteuerter Schalter (8) parallelgeschaltet ist und der zwischen Masse und einer Konstantstromquelle liegt, die ihrerseits mit der Vorpannungsquelle (+V) verbunden ist, wobei ein Analogkomparator (13) einen Ausgang und zwei Eingänge hoher Impedanz aufweist, von denen einer zwischen den Kondensator (7) und die Konstantstromquelle angelegt ist und der andere den Eingang des Analog-Digitalwandlers bildet, wobei ein Taktgeber (15) und ein logischer Prozessor (14) die Abwicklung der Analog-Digital-Umwandlungszyklen bewirken und bei jeder Analog-Digital-Unwandlung das Schließen des gesteuerten Schalters (8) steuern, um den Kondensator (7) zu entladen, und dann die Öffnung dieses gesteuerten Schalters (8), um den Kondensator (7) mit konstantem Strom zu laden, und zugleich das Zählen der Taktimpulse (15) und schließlich das Speichern der beim Kippen des Analogkomparators (13) erreichten Zahl steuern,

— einem Spannungsdämpfer (5, 6), der an den Eingang des Analog-Digitalwandlers angeschlossen ist, und

— einem Multiplexer (4) mit zwei Eingängen und einem Ausgang, der eingangsseitig einerseits an den Verbindungspunkt des zu messenden Widerstands (1) und des Bezugswiderstands (2) und andererseits an die Vorspannungsquelle (+V) und ausgangsseitig an den Eingang des Dämpfers (5, 6) angeschlossen ist, wobei der Multiplexer währen jeder Analog-Digitalumwandlung gesteuert wird, um den Eingang des Dämpfers (5, 6) nacheinander mit dem Verbindungspunkt des zu messenden (1) und des Bezugswiderstands (2), dann mit der Vorspannungsquelle (+V) zu verbinden, wobei der Übergang vom einen zum anderen beim ersten Kippen des Analogkomparators (13) geschieht, der dann in seinen Ursprungszustand zurückgeht, um später ein zweites Mal zu kippen, wobei der logische Prozessor (14) des Analog-Digitalwandlers ausgerüstet ist, um nacheinander während jeder Analog-Digital-Umwandlung die Zahl (N) der Taktimpulse (15), die seit der Öffnung des gesteuerten Schalters (8) bis zum ersten Kippen des Analogkomparators (13) gezählt wurden, und die Zahl (D) der Taktimpulse zu speichern, die von der Öffnung des gesteuerten Schalters (8) bis zum zweiten Kippen des Analogkomparators gezählt wurden, und um das Verhältnis der ersten Zahl (N) zur zweiten Zahl (D) zu berechnen, wobei dieses Verhältnis repräsentativ für den Wert des zu messenden Widerstands (1) in Abhängigkeit von dem des Bezugswiderstands (2) ist.

2. Kreis nach Anspruch 1, dadurch gekennzeichnet, daß eine Separatorstufe (3) großer Eingangsimpedanz zwischen den Verbindungspunkt des zu messenden Widerstands (1) und des Bezugswiderstands (2) und den Multiplexer (4) eingefügt ist.

**Claims**

1. A resistance measuring çircuit comprising:

— a reference resistor (2) connected in series with the resistor the resistance of which is to be measured (1) between the terminals of a polarisation voltage source (V+), one of said terminals being connected to earth potential,

— an analog-to-digital simple ramp converter comprising a capacitor (7) shunted by a controlled switch (8) and connected between earth potential and a constant current source which is itself connected to the polarisation voltage source (+V), an analog comparator (13) comprising an output and two inputs of high impedance, one input being connected to the common point of the capacitor (7) and the constant current source, the other input constituting the input of the analog-to-digital converter, a clock device (15) and a logic processor (14) ensuring the execution of the cycles of the analog-to-digital conversion and commanding at each analog-to-digital conversion the closing of the controlled switch (8) for decharging the capacitor (7), then, simultaneously, the opening of this very controlled switch (8) for charging the capacitor at constant current and the counting of the clock pulses (15), and finally the memorization of the number reached at the switching-over of the analog comparator (13),

— a voltage attenuator (5, 6) connected to the input of the analog-to-digital converter, and

— a multiplexer with two inputs and one output, one input being connected to the common point of the resistor to be measured (1) and the reference resistor (2), the other input being connected to the polarisation voltage source (+V), whereas the output is connected to the input of the attenuator (5, 6), said multiplexer being controlled during each analog-to-digital conversion cycle for connecting the input of the attenuator (5, 6) successively to the common point of the resistor to be measured (1) and the reference resistor (2), then to the polarisation voltage source (+V), the passage from one to the other being carried out at the first switching-over of the analog comparator which returns to its initial state and switches over again later on, the logic processor (14) of the analog-to-digital converter being able to memorize successively during each analog-to-digital conversion cycle the number (N) of clock pulses (15) counted from the opening of the controlled switch (8) up to the first switching over of the analog comparator (13), and the number (D) of clock pulses (15) counted from the opening of the controlled switch (8) up to the second switching over of the analog comparator (13), and to calculate the ratio of the first number (N) by the second (D), this

11

**0 053 786**

12

ratio being representative for the resistance value to be measured (1) in dependance of the reference resistor (2).

2. A circuit according to claim 1, characterized in that a separator stage (3) with high input impedance is interposed between the common point of the resistor to be measured (1) and of the reference resistor (2), and the multiplexer (4).

# FIG.1

# FIG.2